# FASCICULE DE BREVET EUROPEEN

(11) **EP 1 304 795 B1**
(45) Date de publication et mention de la délivrance du brevet: **28.06.2006**
(21) Numéro de dépôt: 01203968.1
(22) Date de dépôt: 22.10.2001
(51) Int. Cl.: H03D 7/14

(54) **Mélangeur pour récepteur à double conversion**
Zweifacher Mischer
Mixer for double frequency conversion

(43) Date de publication de la demande: 23.04.2003
(73) Titulaire: ASULAB S.A., 2074 Marin (CH)
(72) Inventeur: Casagrande, Arnaud, 2523 Lignières (CH)
(74) Mandataire: Thérond, Gérard Raymond

(56) Documents cités:
- US-A- 5 448 772
- US-A- 6 144 846

## Description

La présente invention concerne une structure de mélangeur utilisée notamment dans un récepteur à double conversion. Ce type de récepteur est notamment utilisé dans la téléphonie mobile.
Le mélangeur comprend un premier étage à transconductance variable commandé par un signal porteur haute fréquence, et un deuxième étage connecté au premier étage comprenant en paraiièie des premier et deuxième moyens de commutation commandés respectivement par des premier et deuxième signaux de commande en opposition de phase à une première fréquence intermédiaire, ces premier et deuxième moyens de commutation étant alimentés par un courant sensiblement égal fourni par des moyens de polarisation.

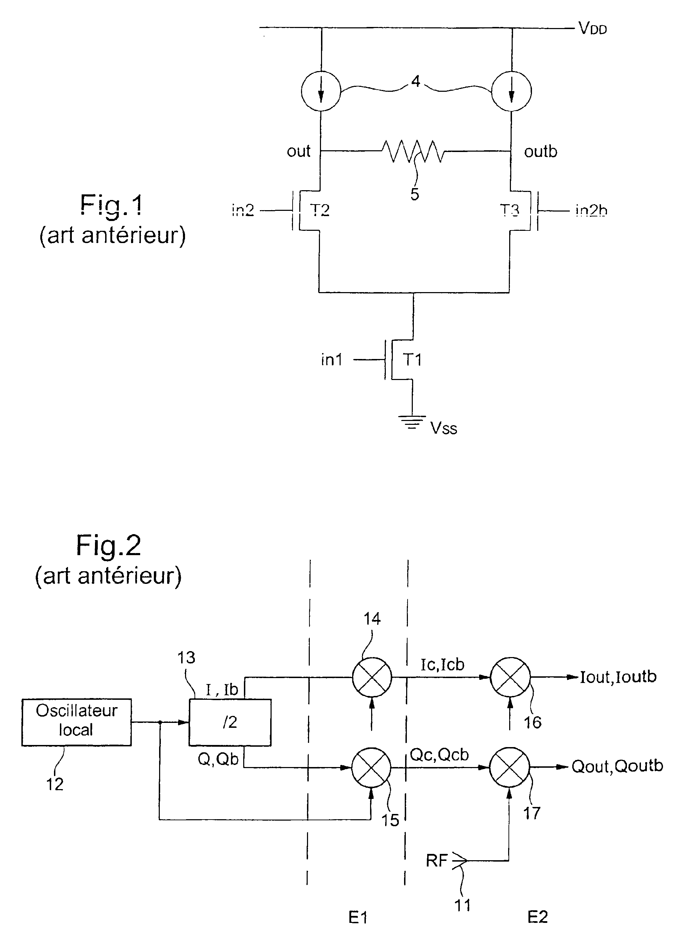

Une telle structure de mélangeur est connu de l'art antérieur comme représentée à la figure 1. Le mélangeur comprend un premier transistor T1 en mode amplificateur ayant sa source reliée à la masse, sa grille commandée par un signal in1 à une fréquence donnée et son drain relié à la source de premier T2 et deuxième T3 transistors en mode commutateur. Le signal de commande du transistor en mode amplificateur peut être soit un signal extérieur haute fréquence RF reçu au moyen d'une antenne non représentée, soit un signal délivré directement par un oscillateur local à sa fréquence propre. Les premier T2 et deuxième T3 transistors en mode commutateur reçoivent sur leur grille des signaux de commande in2 et in2b en opposition de phase à une fréquence intermédiaire IF inférieure à la fréquence du signal de commande du transistor T1 en mode amplificateur. Il est prévu des moyens de polarisation 4 de ces transistors T2 et T3 en mode commutateur, sous la forme de sources de courant connectées à leur drain.

Les deux transistors T2 et T3 en mode commutateur permettent notamment de décaler la fréquence du signal de commande du transistor T1 en mode amplificateur, soit en l'abaissant soit en l'élevant. Ainsi, en sortie du mélangeur, c'est-à-dire aux drain de ces deux transistors T2 et T3, des signaux en opposition de phase out et outb aux fréquences RF-IF et RF+IF sont notamment présents. Les signaux utiles en sortie étant des signaux de courant, il est prévu entre le drain de ces transistors T2 et T3 en mode commutateur une résistance 5 servant de convertisseur courant-tension.

De tels mélangeurs sont utilisés dans un récepteur à double conversion afin d'abaisser la haute fréquence du signal RF reçu à une fréquence en bande de base. Un récepteur utilisant de tels mélangeurs est représenté à la figure 2. Le récepteur comprend au moins une antenne 11 accordée de manière à recevoir des signaux extérieurs à une haute fréquence RF donnée, par exemple 900 MHz. Un oscillateur local 12 délivre un signal d'horloge à une fréquence inférieure LO au signal RF reçu par l'antenne 11, par exemple 600 MHz. Une première sortie de l'oscillateur local est connectée à des moyens diviseurs de fréquence 13 qui permettent d'obtenir des signaux quadriphasés I, Ib, Q et Qb à une fréquence intermédiaire IF, par exemple 300 MHz.

Un premier étage de conversion E1 composé de deux mélangeurs 14 et 15, tels que définis à la figure 1, permet d'obtenir en sortie dudit étage E1 des signaux quadriphasés Ic, Icb, Qc et Qcb décalés à la fréquence RF du signal extérieur reçu, par exemple 900 MHz.

Le premier mélangeur 14 reçoit comme signaux de commande des deux transistors en mode commutateur, définis à la figure 1, des signaux en opposition de phase I et Ib à la fréquence intermédiaire IF (300 MHz) et comme signal de commande du transistor en mode amplificateur, également décrit à la figure 1, le signal d'horloge de l'oscillateur local 12 (600 MHz). Les signaux obtenus Ic et Icb en sortie de ce mélangeur sont des signaux en opposition de phase notamment à la fréquence LO+IF.

Le deuxième mélangeur 15 reçoit comme signaux de commande des deux transistors en mode commutateur des signaux en quadrature de phase Q et Qb par rapport aux signaux de commandes I et Ib du mélangeur 14 et comme signal de commande du transistor en mode amplificateur le signal d'horloge de l'oscillateur local 12.

Ainsi en sortie des deux mélangeurs 14 et 15, des signaux quadriphasés Ic, Icb, Qc et Qcb sont obtenus, notamment à la fréquence RF mais également aux fréquences IF, LO, LO-IF.

Il important de noter que la fréquence LO du signal d'horloge de l'oscillateur local 12 et la fréquence intermédiaire IF des signaux en sortie des moyens diviseurs de fréquence 13 sont choisies de telle manière que l'addition de ces fréquences LO + IF correspond à la fréquence RF du signal extérieur reçu.

Le récepteur comprend également un deuxième étage E2 de réception et conversion constitué également de deux mélangeurs 16 et 17 comme décrits à la figure 1.

Le troisième mélangeur 16 reçoit comme signaux de commande des deux transistors en mode commutateur les signaux Ic et Icb en opposition de phase délivrés en sortie du mélangeur 14 et comme signal de commande du transistor en mode amplificateur un signal extérieur haute fréquence RF reçu par l'antenne 11.

Le quatrième mélangeur 17 reçoit comme signaux de commande des deux transistors en mode commutateur les signaux Qc et Qcb en quadrature de phase par rapport aux signaux de commande Ic et Icb du troisième mélangeur 16, délivrés en sortie du deuxième mélangeur 15 et comme signal de commande du transistor en mode amplificateur le signal extérieur haute fréquence RF reçu par l'antenne 11.

Des signaux quadriphasés lout, loutb, Qout et Qoutb en bande de base sont notamment délivrés en sortie des transistors en mode commutateur des troisième et quatrième mélangeurs 16 et 17. Des signaux à différentes fréquences sont également délivrés en sortie, par exemple RF, IF, LO, RF+LO+IF...

L'inconvénient majeur d'un tel récepteur vient de ce qu'il impose l'utilisation de quatre mélangeurs 14, 15, 16 et 17 pour obtenir des signaux quadriphasés en bande de base. Chaque mélangeur comprend des moyens de polarisation 4 des transistors en mode commutateur. Classiquement, ces moyens de polarisation sont des sources de courant. L'utilisation de quatre mélangeurs entraîne la nécessité de disposer de huit sources de courant. Ce genre de récepteur étant principalement destiné à des applications telles que la téléphonie mobile, la réduction de la consommation de courant est un aspect fondamental. Le récepteur tel que présenté à la figure 2 consomme trop de courant, tout en occupant une place importante sur le circuit intégré. Le document US 6 144 846 décrit un circuit mélangeur entièrement différentielle.

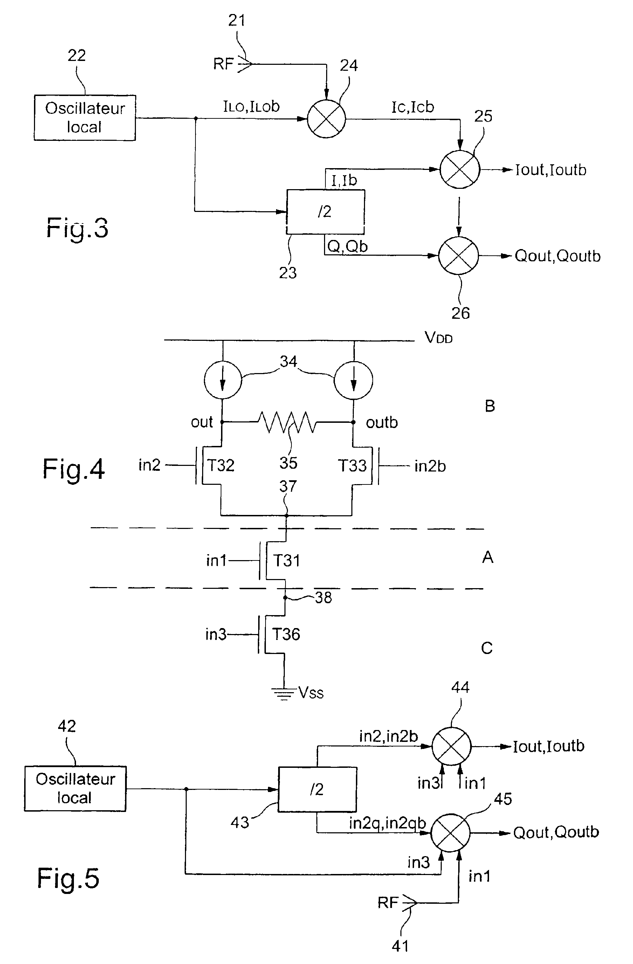

Une solution envisageable par l'homme du métier serait de combiner différemment une structure de mélangeur tel que décrit à la figure 1, pour obtenir un récepteur à double conversion en utilisant seulement trois mélangeurs. Un tel récepteur est présenté à la figure 3.

Comme pour celui présenté à la figure 2, le récepteur comprend au moins une antenne 21 accordée de manière à recevoir des signaux extérieurs à une haute fréquence RF donnée. Un oscillateur local 22 délivre un signal d'horloge à une fréquence LO inférieure à une fréquence RF du signal reçu par l'antenne 21. Une première sortie de l'oscillateur local 22 est connectée à des moyens diviseurs de fréquence 23 qui permettent d'obtenir des signaux quadriphasés I, Ib, Q, Qb à une fréquence intermédiaire IF.

Un premier mélangeur 24 permet d'abaisser la fréquence du signal extérieur haute fréquence RF reçu par l'antenne 21 à la fréquence intermédiaire IF. Pour cela, le mélangeur 24 reçoit comme signaux de commande des deux transistors en mode commutateur, décrits à la figure 1, des signaux Ilo et Ilob en opposition de phase à la fréquence LO de l'oscillateur local 22 et comme signal de commande du transistor en mode amplificateur, décrit également à la figure 1, le signal extérieur à une haute fréquence RF reçu par l'antenne 21.

Des signaux Ic et Icb, décalés en fréquence, notamment à la fréquence intermédiaire IF sont délivrés en sortie des transistors en mode commutateur du premier mélangeur 24.

Des deuxième 25 et troisième 26 mélangeurs permettent d'abaisser la fréquence IF du signal obtenu Ic en sortie du premier mélangeur 24, pour obtenir des signaux quadriphasés lout, loutb, Qout et Qoutb en bande de base.

Le deuxième mélangeur 25 reçoit comme signaux de commande des deux transistors en mode commutateur des signaux I et lb en opposition de phase à la fréquence intermédiaire IF fournis en sortie des moyens diviseurs de fréquence 23 et comme signal de commande du transistor en mode amplificateur le signal Ic à la fréquence intermédiaire IF délivré en sortie du premier mélangeur 24.

Le troisième mélangeur 26 reçoit comme signaux de commande des deux transistors en mode commutateur des signaux Q et Qb en quadrature de phase par rapport aux signaux de commande I et Ib du deuxième mélangeur 25, fournis en sortie des moyens diviseurs de fréquence 23, et comme signal de commande du transistor en mode amplificateur le signal Ic à la fréquence intermédiaire IF délivré en sortie du premier mélangeur 24.

Les signaux fournis en sortie du récepteur sont des signaux quadriphasés lout, loutb, Qout et Qoutb en bande de base.

Le récepteur selon cette solution présente encore une consommation de courant ainsi qu'une occupation spatiale sur le circuit intégré, trop importantes. Trois mélangeurs sont encore nécessaires et de plus les signaux de commande des deux mélangeurs 25 et 26 étant fournis par le même mélangeur 24, la consommation de courant de ce mélangeur 24 est plus importante que la consommation normale d'un seul mélangeur classique.

Afin de pallier les inconvénients de l'art antérieur sus-présenté, l'invention est remarquable en ce qu'elle concerne une structure de mélangeur permettant de réaliser la fonction de double conversion avec une consommation fortement réduite.

Pour cela, l'invention concerne un mélangeur tel que défini en préambule caractérisé en ce qu'il comprend en outre des moyens de modulation du premier signal délivré par le premier étage au moyen d'un troisième signal de commande à une seconde fréquence intermédiaire.

L'invention concerne également un récepteur à double conversion utilisant deux mélangeurs selon l'invention.

L'invention va être expliquée ci-dessous en détail pour un mode d'exécution donné uniquement à titre d'exemple, cette exécution étant illustrée par les dessins annexés dans lesquels :
La figure 1,déjà décrite, est une structure de mélangeur selon l'art antérieur ;
La figure 2, déjà décrite, est un récepteur à double conversion selon l'art antérieur ;
La figure 3, déjà décrite, est un autre récepteur à double conversion ;
La figure 4 est une structure de mélangeur selon l'invention ;
La figure 5 est un récepteur à double conversion selon l'invention ;

La structure de mélangeur, selon l'invention, présentés à la figure 4, comprend notamment des premier et deuxième étages similaires à ceux présentés dans le cadre de l'art antérieur à la figure 1.

Le premier étage à transconductance variable A peut être formé par un premier transistor T31 en mode amplificateur. Ce transistor est commandé à sa grille par un signal de commande in1 haute fréquence RF, par exemple 900 MHz, reçu par une antenne non représentée. Son drain et sa source forment deux bornes, respectivement 37 et 38 délivrant un signal utile. Dans le cadre de cette application, ce signal utile est un courant variable en fonction du signal de commande in1 reçu sur la grille de ce premier transistor T31 en mode amplificateur.

Le deuxième étage B connecté à la borne 37 du premier étage A comprend des moyens de commutation formé par des premier T32 et deuxième T33 transistors en mode commutateur. Ces premier et deuxième transistors T32 et T33 en mode commutateur sont respectivement commandés à leur grille par des signaux de commande, in2 et in2b, en opposition de phase à une première fréquence intermédiaire IF1, par exemple 300 MHz. Les transistors T32 et T33 sont respectivement reliés à la borne 37 du premier étage A par leur source, et sont respectivement alimentés à leur drain par des sources de courant 34 servant de moyens de polarisation de ces transistors T32 et T33. De préférence, une résistance 5 est placée entre le drain de ces deux transistors T32 et T33, cette résistance 5 servant de convertisseur courant-tension.

Le courant délivré par les deux sources de courant 34 est choisi pour être sensiblement le même. Les signaux de commande in2 et in2b des premier et deuxième transistors T32 et T33 en mode commutateur étant en opposition de phase, le courant traversant ces transistors est alternativement interrompu sur l'un ou sur l'autre des deux transistors. Le courant moyen reçu à la borne 37 par le premier transistor T31 en mode amplificateur est sensiblement égal à celui délivré par les sources de courant 34. Le premier transistor T31 en mode amplificateur se comporte comme une transconductance variable et permet de fournir un courant variable fonction du signal de commande in1 reçu sur sa grille, à des moyens de modulation. Ces moyens de modulation du courant traversant le mélangeur permettent de réaliser une deuxième fonction de mélange sans augmenter la consommation du mélangeur initial de la figure 1.

Les moyens de modulation sont de préférence formés par un troisième étage à transconductance C placé à la borne 38 du premier étage A. Ce troisième étage à transconductance C comprend un deuxième transistor T36 en mode amplificateur commandé à sa grille par un signal de commande in3 à une deuxième fréquence intermédiaire IF2. Les deux bornes de ce troisième étage C, soient la source et le drain du deuxième transistor T36 en mode amplificateur, sont connectées respectivement à un potentiel de référence Vss et à la borne 38 du premier étage A.

Le but recherché par l'utilisation d'une telle structure de mélangeur selon la figure 4, est d'abaisser la fréquence RF du signal porteur in1, contenant le signal utile, reçu à la grille du transistor T31 du premier étage A à une fréquence en bande de base pour pouvoir récupérer ce signal utile.

A la borne 38, le signal fourni est à la même fréquence IF2 que celle du signal de commande in3 du troisième étage C, soit à la seconde fréquence intermédiaire. La première fonction de mélange est réalisée au premier étage A au travers du transistor T31 qui permet de décaler la fréquence du signal de commande in1 et notamment de l'abaisser à la fréquence RF-IF2, à la borne 37. Des signaux aux fréquences RF, IF2, RF+IF2 sont également présents à cette borne 37. Des moyens de filtrage passe-bande, non représentés, autour de la fréquence RF-IF2 peuvent être prévus entre le premier étage A et le deuxième étage B afin de ne garder que le signal utile à la fréquence abaissée désirée, soit par exemple 300MHz.

La deuxième fonction de mélange est réalisée au deuxième étage B aux moyens des deux transistors T32 et T33 qui permettent d'abaisser la fréquence du signal utile reçu à la borne 37, à une fréquence en bande de base, RF-IF2-IF1, aux bornes de sortie out et outb. Les signaux obtenus à ces bornes de sortie out et outb sont en opposition de phase. D'autres signaux à différentes fréquences, par exemple RF, IF2, IF1, RF+IF2+IF1, sont également présents à ces deux bornes de sortie. Des moyens de filtrage passe-bas, non représentés, peuvent être prévus en sortie du mélangeur pour ne garder que les signaux utiles en bande de base.

Dans le cadre de cet exemple d'application, les signaux récupérés aux bornes de sortie out et outb sont des signaux de courant, c'est pourquoi, il est prévu préférentiellement de placer en sortie un convertisseur courant-tension afin de transformer les signaux récupérés en des signaux de tension. Ce convertisseur courant-tension est réalisé par exemple par l'addition d'une résistance 5 entre les deux bornes de sortie out et outb du mélangeur.

II est néanmoins possible d'envisager un mélangeur à double conversion selon l'invention permettant de récupérer directement des signaux de tension en sortie ou encore d'utiliser les signaux de courant récupérés sans les convertir.

La figure 5 représente un récepteur à double conversion utilisant deux mélangeurs selon la figure 4.

Le récepteur comprend, comme pour celui présenté à la figure 2, au moins une antenne 41 accordée de manière à recevoir des signaux extérieurs à une haute fréquence RF donnée. Un oscillateur local 42 délivre un signal d'horloge à une fréquence propre IF2 inférieure au signal RF reçu par l'antenne 41. Une première sortie de l'oscillateur local est connectée à des moyens diviseurs de fréquence 43 qui permettent d'obtenir des signaux quadriphasés (in2, in2b, in2q et in2qb) à une fréquence intermédiaire IF1 dépendante de la fréquence propre IF2 de l'oscillateur local 42, par exemple un rapport deux, la fréquence propre IF2 de l'oscillateur local étant deux fois supérieure à la fréquence intermédiaire IF1.

Le récepteur comprend également deux mélangeurs 44 et 45 selon l'invention permettant de délivrer à leurs sorties des signaux quadriphasés lout, loutb, Qout et Qoutb en bande de base.

Le premier mélangeur 44 reçoit le signal d'horloge délivré par l'oscillateur local 42 comme signal de commande de son premier étage, les signaux in2 et in2b en opposition de phase à la fréquence intermédiaire IF1 comme signaux de commande de son deuxième étage, et le signal porteur RF délivrée par l'antenne comme signal de commande de son troisième étage.

Le deuxième mélangeur reçoit le signal d'horloge délivré par l'oscillateur local comme signal de commande de son premier étage, les signaux in2q et in2qb en quadrature de phase des signaux in2 et in2b à la fréquence intermédiaire IF1 comme signaux de commande de son deuxième étage, et le signal porteur RF délivrée par l'antenne comme signal de commande de son troisième étage.

Chaque mélangeur réalise comme décrit à la figure 4, un double mélange avec la consommation de courant d'un seul mélangeur. Ainsi, la consommation de courant du récepteur est fortement réduite.

Le récepteur selon l'invention est susceptible de fonctionner dans toutes les bandes de fréquences de la téléphonie mobile, par exemple 1,8 GHz, il suffit pour cela d'adapter la fréquence de l'oscillateur local et le nombre d'étages des moyens diviseurs de fréquence.

Il est bien entendu que la description n'est donnée qu'à titre d'exemple et que d'autres modes de réalisation, en particulier du récepteur à double conversion, peuvent faire l'objet de la présente invention.

## Revendications

1. Mélangeur, notamment pour récepteur à double conversion, comprenant :
- un premier étage (A) à transconductance variable commandé par un signal porteur (in1) haute fréquence, ce premier étage comprenant des première (37) et deuxième (38) bornes délivrant un premier signal de courant; et
- un deuxième étage (B) connecté à ladite première borne du premier étage comprenant en parallèle des premier (T32) et deuxième (T33) moyens de commutation commandés respectivement par des premier (in2) et deuxième (in2b) signaux de commande en opposition de phase à une première fréquence intermédiaire (IF1), ces premier et deuxième moyens de commutation étant alimentés par un courant sensiblement égal fourni par des moyens de polarisation (34) ;
**caractérisé en ce que** le mélangeur comprend en outre des moyens de modulation (T36) dudit premier signal délivré par ledit premier étage au moyen d'un troisième signal (in3) de commande à une deuxième fréquence intermédiaire (IF2) lesdits moyens de modulation étant connectés entre la deuxième borne (38) du premier étage (A) et un potentiel de référence (VSS).

2. Mélangeur selon la revendication 1, **caractérisé en ce que** lesdits moyens de modulation comprennent un troisième étage (C) à transconductance comprenant des première (38) et seconde (Vss) bornes respectivement connectées à la seconde borne du premier étage et à un potentiel de référence.

3. Mélangeur selon la revendication 1 ou 2, **caractérisé en ce qu'**il comprend en outre des moyens de filtrage passe-bande autour de la fréquence du signal délivré à la première borne du premier étage, ces moyens de filtrage passe-bande étant placés entre lesdits premier et deuxième étage, et des moyens de filtrage passe-bas connectés à au moins une première sortie (out) du deuxième étage et un convertisseur courant-tension (35) placé entre ladite première sortie et une deuxième sortie (outb) du deuxième étage.

4. Mélangeur selon la revendication 2 ou 3, **caractérisé en ce que** la transconductance variable du premier étage est constitué par un premier transistor (T31) en mode amplificateur, les premier et deuxième moyens de commutation du deuxième étage sont respectivement constitués par des premier et deuxième transistors en mode commutateur, et la transconductance du troisième étage est constituée par un deuxième transistor en mode amplificateur.

5. Mélangeur selon l'une quelconque des revendications précédentes, **caractérisé en ce que** la somme des première et deuxième fréquences intermédiaires soit égale à la fréquence du signal porteur.

6. Récepteur à double conversion comprenant
- des premier (44) et deuxième (45) mélangeurs selon l'une des revendications précédentes,
- au moins une antenne (41) recevant un signal extérieur haute fréquence (RF); et
- un oscillateur local (42) ayant une première sortie connectée à des moyens diviseurs de fréquence (43) délivrant des premier (in2), deuxième (in2b), troisième (in2q) et quatrième (in2qb) signaux de commande quadriphasés à une première fréquence intermédiaire (IF1), et une deuxième sortie fournissant un troisième signal (in3) de commande à un deuxième fréquence intermédiaire (IF2),
**caractérisé en ce que**
- ledit premier mélangeur (44) reçoit comme signaux de commande, ledit signal extérieur haute fréquence pour commander le premier étage (A), lesdits premier (in2) et deuxième (in2b) signaux de commande quadriphasés à une première fréquence intermédiaire pour commander le deuxième étage (B) et ledit troisième signal (in3) de commande à une deuxième fréquence intermédiaire pour commander le troisième étage (C) ;
et **en ce que**
- ledit deuxième mélangeur (45) reçoit comme signaux de commande, ledit signal extérieur haute fréquence pour commander le premier étage, lesdits troisième (in2q) et quatrième (in2qb) signaux de commande quadriphasés à une première fréquence intermédiaire pour commander le deuxième étage et ledit troisième signal de commande à une deuxième fréquence intermédiaire pour commander le troisième étage.

## Claims

1. Mixer, in particular for a dual conversion receiver, including:
- a first variable transconductance stage (A) controlled by a high frequency carrier signal (in1), said first stage including first (37) and second (38) terminals delivering a first current signal; and
- a second stage (B) connected to said first terminal of said first stage including, in parallel, first (T32) and second (T33) switching means respectively controlled by first (in2) and second (in2b) phase opposition control signals at a first intermediate frequency (IF1), said first and second switching means being powered by a substantially equal current supplied by polarisation means (34);
**characterised in that** said mixer further includes means (T36) for modulating said first signal delivered by said first stage by means of a third control signal (in3) at a second intermediate frequency (IF2), said modulation means being connected between the second terminal (38) of the first stage (A) and a reference potential (Vss).

2. Mixer according to claim 1, **characterised in that** said modulation means include a third transconductance stage (C) including first (38) and second (Vss) terminals respectively connected to said second terminal of the first stage and to a reference potential.

3. Mixer according to claim 1 or 2, **characterised in that** it further includes pass-band filtering means around the frequency of said first signal delivered at said first and second terminals of said first stage, said pass-band filtering means being placed between said first and second stage, and low-pass filtering means connected to at least a first output (out) of said second stage and a current-voltage converter (35) placed between said first output and a second output (outb) of said second stage.

4. Mixer according to claim 2 or 3, **characterised in that** the variable transconductance of said first stage is formed by a first amplifying mode transistor (T31), said first and second switching means of said second stage being respectively formed by first and second switching mode transistors, and the transconductance of said third stage is formed by a second amplifying mode transistor.

5. Mixer according to any one of the preceding claims, **characterised in that** the sum of said first and second intermediate frequencies is equal to the frequency of the carrier signal.

6. Dual conversion receiver including
- first (44) and second (45) mixers according to any of the preceding claims,
- at least one antenna (41) receiving an external high frequency signal (RF), and
- a local oscillator (42) having a first output connected to frequency divider means (43) delivering first (in2), second (in2b), third (in2q) and fourth (in2qb) four-phase control signals at a first intermediate frequency (IF1), and a second output supplying a fifth control signal (in3) at a second intermediate frequency (IF2),
**characterised in that**
- said first mixer (44) receives as control signals, said external high frequency signal to control the first stage (A), said first (in2) and second (in2b) four-phase control signals at a first intermediate frequency to control the second stage (B) and said fifth control signal (in3) at a second intermediate frequency to control the third stage (C);
and **in that**
- said second mixer (45) receives as control signals, said external high frequency signal to control the first stage, said third (in2q) and fourth (in2qb) four-phase control signals at a first intermediate frequency to control the second stage and said fifth control signal at a second intermediate frequency to control the third stage.

## Patentansprüche

1. Mischer, insbesondere für einen Empfänger mit Doppelumsetzung, der umfasst:
- eine erste Stufe (A) mit variabler Transkonduktanz, die durch ein Hochfrequenz-Trägersignal (in1) gesteuert wird, wobei diese erste Stufe einen ersten Anschluss (37) und einen zweiten Anschluss (38) aufweist, die ein erstes Stromsignal liefern; und
- eine zweite Stufe (B), die an den ersten Anschluss der ersten Stufe angeschlossen ist und in Parallelschaltung ein erstes Umschaltmittel (T32) und ein zweites Umschaltmittel (T33) umfasst, die durch ein erstes Steuersignal (in2) bzw. ein zweites Steuersignal (in2b), die gegenphasig sind und eine erste Zwischenfrequenz (IF1) besitzen, gesteuert werden, wobei dieses erste und zweite Umschaltmittel mit einem im Wesentlichen gleichen Strom, der von Vorspannungsmitteln (34) geliefert wird, versorgt werden;
**dadurch gekennzeichnet, dass** der Mischer außerdem Mittel (T36) für die Modulation des von der ersten Stufe gelieferten ersten Signals mittels eines dritten Steuersignals (in3) mit einer zweiten Zwischenfrequenz (IF2) umfasst, wobei diese Modulationsmittel zwischen den zweiten Anschluss (38) der ersten Stufe (A) und ein Referenzpotential (Vss) geschaltet sind.

2. Mischer nach Anspruch 1, **dadurch gekennzeichnet, dass** die Modulationsmittel eine dritte Stufe (C) mit Transkonduktanz umfassen, die einen ersten Anschluss (38) und einen zweiten Anschluss (Vss) aufweist, die an den zweiten Anschluss der ersten Stufe bzw. an ein Referenzpotential angeschlossen sind.

3. Mischer nach Anspruch 1 oder 2, **dadurch gekennzeichnet, dass** er außerdem Bandpassfiltermittel um die Frequenz des an den ersten Anschluss der ersten Stufe gelieferten Signals, die zwischen der ersten und der zweiten Stufe angeordnet sind, Tiefpassfiltermittel, die an wenigstens einen ersten Ausgang (out) der zweiten Stufe angeschlossen sind, und einen Strom/Spannungs-Umsetzer (35), der zwischen den ersten Ausgang und einen zweiten Ausgang (outb) der zweiten Stufe angeordnet ist, umfasst.

4. Mischer nach Anspruch 2 oder 3, **dadurch gekennzeichnet, dass** die variable Transkonduktanz der ersten Stufe durch einen ersten Transistor (T31) im Verstärkerbetrieb gebildet ist, wobei das erste und das zweite Umschaltmittel der zweiten Stufe durch erste bzw. zweite Transistoren im Umschaltbetrieb gebildet sind und die Transkonduktanz der dritten Stufe durch einen zweiten Transistor im Verstärkerbetrieb gebildet ist.

5. Mischer nach einem der vorhergehenden Ansprüche, **dadurch gekennzeichnet, dass** die Summe aus der ersten und der zweiten Zwischenfrequenz gleich der Frequenz des Trägersignals ist.

6. Empfänger mit doppelter Umsetzung, der umfasst:
- einen ersten Mischer (44) und einen zweiten Mischer (45) nach einem der vorhergehenden Ansprüche,
- wenigstens eine Antenne (41), die ein externes Hochfrequenzsignal (HF) empfängt, und
- einen Hilfsoszillator (42), wovon ein erster Ausgang mit Frequenzteilermitteln (43) verbunden ist, die das erste Steuersignal (in2), das zweite Steuersignal (in2b), das dritte Steuersignal (in2q) und das vierte Steuersignal (in2qb) liefern, die in Bezug auf eine erste Zwischenfrequenz (IF1) vierfach phasenverschoben sind, und wovon ein zweiter Ausgang ein drittes Steuersignal (in3) mit einer zweiten Zwischenfrequenz (IF2) liefert,
**dadurch gekennzeichnet, dass**
- der erste Mischer (44) als Steuersignale das externe Hochfrequenzsignal, um die erste Stufe (A) zu steuern, das erste Steuersignal (in2) und das zweite Steuersignal (in2b), die vierfach phasenverschoben sind und eine erste Zwischenfrequenz besitzen, um die zweite Stufe (B) zu steuern, und das dritte Steuersignal (in3) mit einer zweiten Zwischenfrequenz, um die dritte Stufe (C) zu steuern, empfängt;
und dass
- der zweite Mischer (45) als Steuersignale das externe Hochfrequenzsignal, um die erste Stufe zu steuern, das dritte Steuersignal (in2q) und das vierte Steuersignal (in2qb), die vierfach phasenverschoben sind und eine erste Zwischenfrequenz besitzen, um die zweite Stufe zu steuern, und das dritte Steuersignal mit einer zweiten Zwischenfrequenz, um die dritte Stufe zu steuern, empfängt.
